Europäisches Patentamt

European Patent Office

Office européen des brevets

(11) Publication number: **0 130 774**
**B1**

## (12) EUROPEAN PATENT SPECIFICATION

(45) Date of publication of patent specification: **16.09.87**

(21) Application number: **84304305.0**

(22) Date of filing: **26.06.84**

(51) Int. Cl.⁴: **H 01 L 29/72,** H 01 L 29/205, H 01 L 21/265

(54) Process for fabricating bipolar transistor.

(30) Priority: **30.06.83 JP 119097/83**

(43) Date of publication of application:
**09.01.85 Bulletin 85/02**

(45) Publication of the grant of the patent:
**16.09.87 Bulletin 87/38**

(84) Designated Contracting States:
**DE FR GB**

(56) References cited:
FR-A-2 436 502

ELECTRONICS LETTERS, vol. 19, no. 10, May 1983, London, GB; D.L. MILLER et al. "(GaA1)As/GaAs Heterojunction bipolar transistors with graded composition in the base", pages 367, 368

ELECTRONICS LETTERS, vol. 16, no. 1, January 1980, Hitchin, GB; D. ANKRI et al. "Design and evaluation of a planar GaA1As-GaAs bipolar transistor", pages 41, 42

(73) Proprietor: **FUJITSU LIMITED**
**1015, Kamikodanaka Nakahara-ku**
**Kawasaki-shi Kanagawa 211 (JP)**

(72) Inventor: **Yokoyama, Naoki**
**Riba Haitsu 326 2557-1, Tsumada**
**Atsugi-shi Kanagawa 243 (JP)**
Inventor: **Ohshima, Toshio**
**1-8-104, Tobio 3-chome**
**Atsugi-shi Kanagawa 243-02 (JP)**

(74) Representative: **Fane, Christopher Robin King et al**
**HASELTINE LAKE & CO. Hazlitt House 28 Southampton Buildings Chancery Lane London, WC2A 1AT (GB)**

(56) References cited:
JAPANESE JOURNAL OF APPLIED PHYSICS. SUPPLEMENTS vol. 22, supplement no. 22-1, 1983, Tokyo, JP; J.S. HARRIS et al. "Heterojunction bipolar transistors", pages 375-380

Courier Press, Leamington Spa, England.

0  130  774

(56) References cited:
JOURNAL OF APPLIED PHYSICS, vol. 46, no. 5,
May 1975, New York, USA; M. KONAGAI et al.
"(GaA1)As-GaAs heterojunction transistors
with high injection efficiency", pages 2120-2124

PROCEEDINGS OF THE IEEE, vol. 70, no. 1,
January 1982, New York, USA; H. KROEMER
"Heterostructure bipolar transistors and
integrated circuits", pages 13-25

## Description

The present invention relates to a process for fabricating a bipolar transistor, more specifically, a heterojunction bipolar transistor. Such transistors comprise two semiconductor layers of a first conductivity type, separated by a semiconductor layer of second and opposite conductivity type, one of the semiconductor layers of the first conductivity type being made of a semiconductor that has a band gap wider than that of the semiconductor of the separating layer and forming a heterojunction with the separating layer.

Heterojunction bipolar transistors in which the emitter bandgap is wider than the base bandgap, have the advantage of higher emitter efficiency since holes (minority carriers for the emitter) flowing from the base to emitter are blocked by the higher barrier in the valence band (cf. W. Schockley, U.S. Patent No. 2,569,347). The wide bandgap emitter allows the base to be heavily doped without sacrificing emitter efficiency. However, thei cutoff frequency is relatively low, normally a few Gigahertz.

Typical heterojunction bipolar transistors are described by M. Konagai and K. Takahashi, J. Appl. Phys., vol. 46, No. 5, May 1975, pp. 2120—2124. They are fabricated by sequentially forming on a substrate a collector layer, a base layer, and an emitter layer. An emitter electrode is formed on the emitter layer. A base electrode is formed on the same side of the substrate as the emitter electrode near the emitter electrode. However, the base layer is extremely thin, for example, from 50 nm to 100 nm, and the distance from the base electrode or base contact region to the emitter electrode or emitter contact region is, for example, from 1 μm to 2 μm. As a result, the base resistance becomes high, which limits the cutoff frequency, usually to a few Gigahertz.

In order to decrease the base resistance without changing the base thickness and thereby increase the cutoff frequency, part of the emitter layer may be doped through to the base layer so as to form an impurity doped semiconductor region of the same conductivity type as the base layer, the base electrode being formed on this doped region. Such heteropolar transistors are described in "Electronics Letters, vol. 19, No. 10, pp. 367—368.

According to the invention, a process for fabricating a heterojunction bipolar transistor comprising two semiconductor layers of a first conductivity type, separated by a semiconductor layer of second and opposite conductivity type, one of the semiconductor layers of the first conductivity type being made of a semiconductor that has a band gap wider than that of the semiconductor of the separating layer and forming a heterojunction with the separating layer comprises the steps of

successively forming the first, second and third semiconductor layers on a support layer;

forming a first electrode on part of the third semiconductor layer;

carrying out doping of part of the said third semiconductor layer and therethrough to the separating layer (the second semiconductor layer) so as to form an impurity-doped semiconductor region of the second conductivity type reaching said second semiconductor layer; and

forming a second electrode on said impurity-doped semiconductor region is characterised in that the doping of the said third semiconductor layer is carried out using the first electrode as a mask so that the impurity-doped semiconductor region is aligned with an edge of the first electrode.

The doping stage may be carried out using ion implantation.

The steps may comprise forming a first semiconductor layer of a first conductivity type on a substrate; forming a second semiconductor layer of a second conductivity type opposite to the first conductivity type on the first semiconductor layer; forming a third semiconductor layer of the first conductivity type on the second semiconductor layer, the third semiconductor layer being of a semiconductor forming a heterojunction with the second semiconductor layer and having a bandgap wider than that of the second semiconductor layer; forming a first electrode having a pattern on the third semiconductor layer; doping dopants with the first electrode as a mask into and through the third semiconductor layer to form an impurity-doped semiconductor region of the second conductivity type aligned with an edge of the first electrode and reaching the second semiconductor layer; forming a second electrode on the impurity-doped semiconductor region; and forming a third electrode for the first semiconductor layer.

Reference will now be made, by way of example, to the accompanying drawings, in which:

Fig. 1 is an energy-band diagram of an n-p-n heterojunction transistor;

Fig. 2 is an axial sectional view of a prior art heterojunction transistor; and

Fig. 3 to Fig. 6 are sectional views of a heterojunction transistor in the sequential steps of a process according to an embodiment of the present invention.

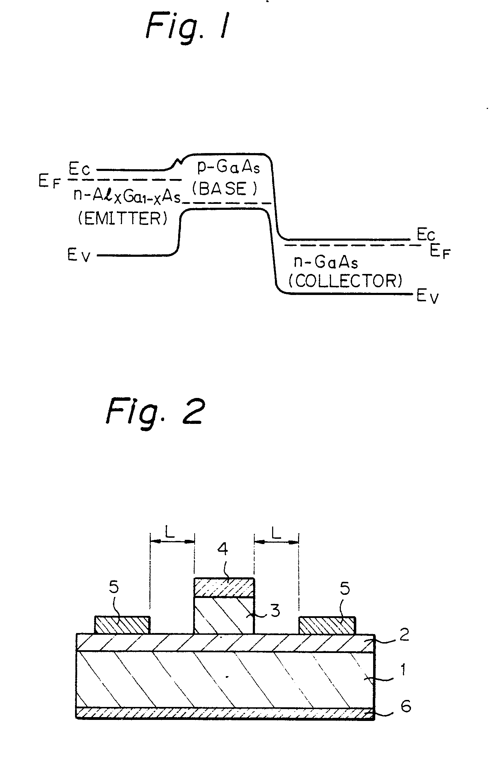

Figure 1 is an energy-band diagram of a heterojunction transistor with a wide bandgap emitter which comprises an n-type aluminum gallium arsenide ($Al_xGa_{1-x}As$) emitter, p-type gallium-arsenide (GaAs) base, and n-type GaAs collector.

In the diagram, $E_v$ represents the energy level of the top of the valence band, $E_c$ the energy level of the bottom of the conductive band, and $E_f$ the energy level of the Fermi level. In the figure, the bandgap of the emitter is wider than that of the base. This wide-bandgap-emitter heterojunction bipolar transistor has the advantage of higher emitter efficiency since, while electrons (majority carriers for the emitter) easily flow from the emitter to the base over the low barrier in the conductive band, holes (minority carriers for the emitter) flowing from the base to emitter are blocked by the high barrier in the valence band.

Figure 2 shows a typical prior art heterojunction bipolar transistor. In the figure, 1 denotes an n-type GaAs collector, 2 a p-type GaAs base, 3 an n-type $Al_xGa_{1-x}As$ emitter, 4 an emitter electrode, 5 a base electrode, and 6 a collector electrode. In the device, the base 2 has a small thickness of, for example, 50 nm to 100 nm, while the horizontal distance L between the base electrode 5 and the emitter electrode 4 or the emitter 3 is over approximately 1 μm. This results from the separate formation of the electrodes 4 and 5 and the mask alignment process used therefor. As a result, the base resistance becomes high, decreasing the cutoff frequency of the device.

In the process of the invention the impurity-doped semiconductor region of the second conductivity type is formed in alignment with the first electrode by a self-alignment process. This allows a decrease in the base resistance and the emitter capacitance. This is made possible by the use, for the first electrode, of material which is heat resistant and allows ohmic contact with the semiconductor.

Annealing after ion implantation is conducted at about 600°C to 1,000°C, for example, at 700°C. Annealing may be effected by flash annealing. The material of the first electrode should withstand this annealing temperature and may be a refractory metal such as tungsten, tantalum, titanium, molybdenum, vanadium, chromium, zirconium, niobium, and hafnium; a silicide such as silicides of refractory metals as mentioned above, platinum silicide, palladium silicide, cobalt silicide, and nickel silicide; germanium; tellurium; silicon; thallium; cobalt, and nickel.

Examples of pairs of semiconductors, usually compound semiconductors, which may be used for the second and third semiconductor layers are shown in the table.

The first semiconductor layer is usually made of the same semiconductor and in the same way as the second semiconductor layer except for the doping conditions, since the layer need not form a heterojunction with the second semiconductor layer.

TABLE

| Second semiconductor layer | Third semiconductor layer |
| --- | --- |
| GaAs | (AlGa)As |
| (InGa)As | InP |
| (InGa)As | (AlIn)As |
| (GaIn)Sb | AlSb |
| In(AsSb) | AlAs |
| GaAs | (GaIn)P |

However, the first semiconductor layer may also be a semiconductor which forms a heterojunction with the second semiconductor layer and has a bandgap wider than that of the second semiconductor layer and may be, for example, the same semiconductor as the third semiconductor layer. In the latter case, a so-called double heterojunction bipolar transistor is formed. The first semiconductor layer may be used as an emitter or a collector in a double heterojunction bipolar transistor.

In a process embodying the present invention, the substrate may be of not only semi-insulating or insulating materials, for example, a nondoped compound semiconductor or silicon, or sapphire, but also of conductive materials, for example, a heavily doped compound semiconductor or silicon. Recently, it has been possible to make excellent compound semiconductors on a silicon or sapphire substrate by using a buffer layer therebetween.

An insulating or semi-insulating substrate may be used in the bipolar transistor, an electrode to the first semiconductor layer being provided on the same side of the substrate as the second and third semiconductor layers. If a conductive substrate is used in the bipolar transistor the electrode to the first semiconductor layer may alternatively be on the side of the substrate opposite to the second and third semiconductor layers.

In another process embodying the present invention, another semiconductor layer of the first conductivity type which has a higher carrier concentration may be inserted between the third semiconductor layer and the first electrode to improve ohmic contact therebetween. This other semiconductor layer is preferably etched in the same form as that of the first electrode, since it is difficult to convert the conductivity type.

A further semiconductor layer of the first conductivity type may be inserted as a buffer layer between the substrate and the first semiconductor layer in order to improve the crystallographic characteristics of the first semiconductor layer.

The doping to form the impurity-doped region in alignment with the first electrode may be conducted not only by ion implantation but also by heat diffusion, for example.

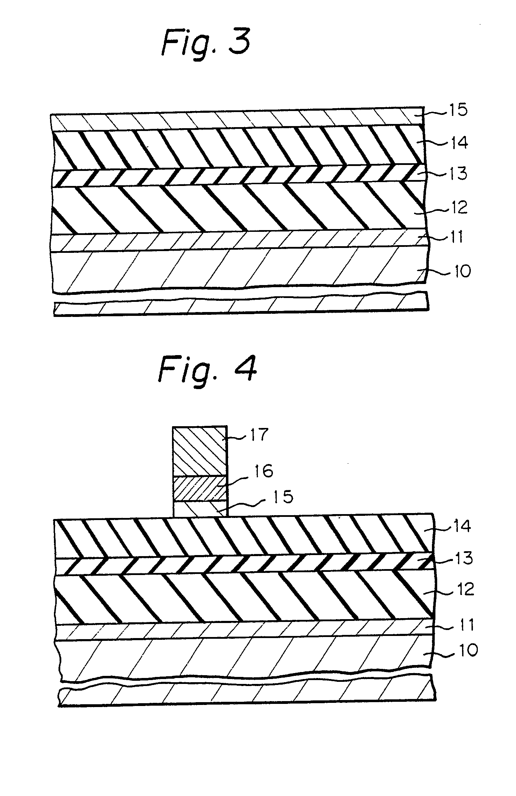

Figure 3 to Figure 6 illustrate the steps of fabricating a heterojunction bipolar transistor according to a specific embodiment of the present invention.

In Fg. 3, on a semi-insulating GaAs substrate 10, an $n^+$-type GaAs buffer layer 11 of the doped impurity concentration of $1 \times 10^{18}$ cm$^{-3}$ is formed in a thickness of 200 nm. An n-type GaAs collector layer 12 of the doped impurity concentration of $1 \times 10^{17}$ cm$^{-3}$ is formed in a thickness of 400 nm on the n-type GaAs collector layer 12. A p-type GaAs base layer 13 of the doped impurity concentration of $1 \times 10^{19}$ cm$^{-3}$ is formed in a thickness of 100 nm on the n-type GaAs collector layer 12. An n-type Al$_{0.3}$Ga$_{0.7}$As emitter layer 14 of a doped impurity concentration of $1 \times 10^{17}$ cm$^{-3}$ is formed in a thickness of 300 nm on the p-type GaAs base layer 13. Finally, an $n^+$-type GaAs ohmic contact layer 15 of a doped impurity concentration of $2 \times 10^{18}$ cm$^{-3}$ is formed in a thickness of 100 nm on the n-type Al$_{0.3}$Ga$_{0.7}$As emitter layer 14. These layers 11 to 15 are continuously formed by molecular beam epitaxy.

The bandgaps of the $p^+$-type GaAs p-type GaAs base layer 13 and the n-type Al$_{0.3}$Ga$_{0.7}$As emitter layer 14 are 1.4 eV and 1.8 eV, respectively.

With respect to the buffer layer 11, alternatively a super lattice layer can be used for improving the crystallographic characteristics of the first semiconductor layer 12.

In Fig. 4, a germanium (Ge) layer 16 of a thickness of 20 nm and a tungsten silicide (W$_5$Si$_3$) layer 17 of a thickness of 500 nm are deposited on the $n^+$-type GaAs ohmic contact layer 15 and patterned to form an emitter electrode of a desired form by photolithography. The $n^+$-type GaAs layer 15 is selectively etched with the electrode layers 16 and 17 as a mask. The etched $n^+$-type GaAs layer 15 has the same shape as that of the emitter electrode 17. Then, by annealing at 700°C for 10 minutes, ohmic contact between the emitter electrode and the $n^+$-type GaAs layer is formed.

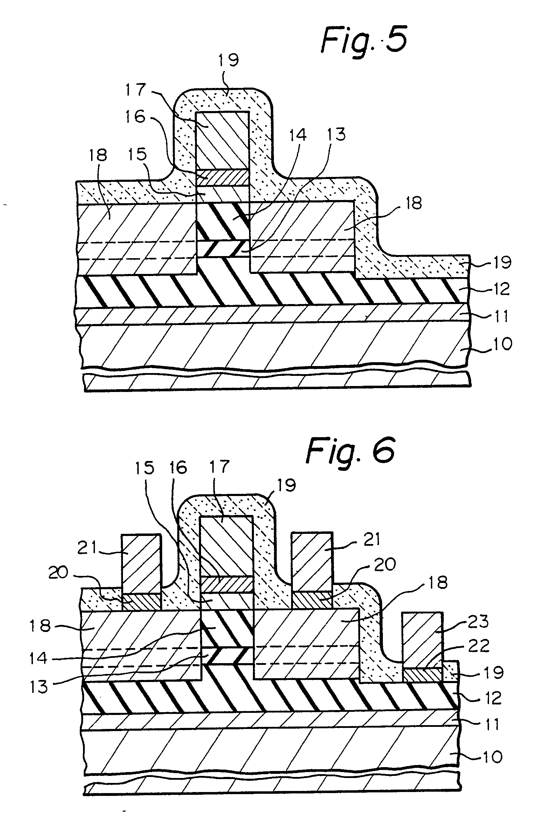

In Fig. 5, beryllium ions (Be$^+$) are ion-implanted into or through the n-type Al$_{0.3}$Ga$_{0.7}$As emitter layer 14 with the emitter electrode 17 as a mask at an electron acceleration energy of 150 keV in a dose of $1 \times 10^{14}$ cm$^{-2}$. Selective etching is conducted in an area separated from the emitter electrode 17 where a collector electrode is to be formed. This selective etching is conducted at least until the n-type GaAs collector layer 12 is exposed. Then, a silicon dioxide layer 19 is formed over the emitter electrodes 16 and 17, the n-type Al$_{0.3}$Ga$_{0.7}$As emitter layer 14, and the n-type GaAs collector layer 12, and heat treatment is conducted to anneal the implanted Be ions. This heat treatment is conducted at 700°C for 20 minutes. Alternatively, the heat treatment may be conducted by flash annealing over, for example, 5 seconds using, for example, a halogen lamp.

After this annealing, the ion-implanted portion of the n-type Al$_{0.3}$Ga$_{0.7}$As emitter layer 14 and the upper part of the n-type GaAs collector layer 12 are changed to a $p^+$-type region 18 including the p-type GaAs base layer 13 except the actual base region under the emitter electrode 17. This $p^+$-type region 18 is formed in alignment with the emitter electrode 17 in accordance with the present invention. As a result, only the actual base region of the p-type GaAs base layer 13 has a small thickness of 100 nm so that the base resistance is decreased. The thus remaining n-type Al$_{0.3}$Ga$_{0.7}$As emitter layer 14 is surrounded by the $p^+$-type region 18 at the sides and by the p-type GaAs base layer 13 thereunder, the p-type GaAs base layer 13 having the same form and area as those of the n-type Al$_{0.3}$Ga$_{0.7}$As emitter layer 14. The n-type GaAs collector layer 12 exists under the p-type GaAs base layer 13. In this structure of a bipolar transistor, electrons in the n-type Al$_{0.3}$Ga$_{0.7}$As emitter layer 14 almost all flow through the p-type GaAs base layer 13 and almost never through the $p^+$-type region 18, i.e., a $p^+$-type Al$_{0.3}$Ga$_{0.7}$As region surrounding the p-type GaAs base layer 13 since the conduction energy band is lower in the p-type GaAs base layer 13 than in the $p^+$-type Al$_{0.3}$Ga$_{0.7}$As region 18. As a result, almost all of the electrons in the n-type Al$_{0.3}$Ga$_{0.7}$As emitter layer 14 are used for operation of the bipolar transistor.

In Fig. 6, windows for base and collector electrodes 21 and 23 are opened in the silicon dioxide layer 19, and a zinc (Zn) layer 20 of a thickness of 20 nm and gold (Au) layer 21 of a thickness of 200 nm are deposited and patterned to form a base electrode and an AuGe layer 22 of a thickness of 30 nm and a gold (Au) layer 23 of a thickness of 200 nm are deposited and patterned to form a collector electrode in the before-formed electrode windows. Thus, a heterojunction bipolar transistor is fabricated.

In resultant heterojunction bipolar transistors, a current amplification coefficient h$_{FE}$ of 1500 and a cutoff frequency f$_t$ of 15 GHz are attained when the emitter size is 3 μm by 30 μm and h$_{FE}$ of 1500 and f$_t$ of 50 GHz when the emitter size is 1 μm by 30 μm.

In another embodiment of the present invention, a double heterojunction bipolar transistor can be fabricated easily by replacing the n-type GaAs collector layer 12 by an n-type Al$_{0.3}$Ga$_{0.7}$As layer. In such a double heterojunction bipolar transistor, either of the n-type Al$_{0.3}$Ga$_{0.7}$As emitter layer 14 or the n-type GaAs collector layer 12 replaced in this embodiment may be used as an emitter. That is to say, the emitter is not limited to the n-type Al$_{0.3}$Ga$_{0.7}$As emitter layer 14. In either case, the bipolar transistor is a heterojunction bipolar transistor with a wide bandgap emitter and the base has a lower resistance.

Accordingly there can be provided a method of fabricating a heterojunction bipolar transistor having a lower base resistance and a higher cutoff frequency of the transistor. After forming a collector layer, a base layer of small thickness, and an emitter layer, ion implantation is carried out into and through the emitter layer except under the emitter electrode formed on the emitter layer to widen the base layer in alignment with the emitter electrode. The self-alignment ion implantation process gives a lower base resistance and is made possible by using a heat resistant metal for the emitter electrode.

**Claims**

1. A process for fabricating a heterojunction bipolar transistor comprising two semiconductor layers of

0 130 774

a first conductivity type, separated by a semiconductor layer of second and opposite conductivity type, one of the semiconductor layers of the first conductivity type being made of a semiconductor that has a band gap wider than that of the semiconductor of the separating layer and forming a heterojunction with the separating layer, comprising the steps of:

successively forming the first (12), second (13) and third (14) semiconductor layers on a support layer (10, 11);

forming a first electrode (17) on part of the third semiconductor layer (14);

carrying out doping of part of the said third semiconductor layer (14) and therethrough to the separating layer (13) (the second semiconductor layer), so as to form an impurity-doped semiconductor region (18) of the second conductivity type reaching said second semiconductor layer; and

forming a second electrode (21) on said impurity-doped semiconductor region (18); characterised in that the doping of the said third semiconductor layer is carried out using the first electrode as a mask so that said impurity-doped semiconductor region (18) is aligned with an edge of the first electrode.

2. A process according to claim 1, wherein said third semiconductor layer is made of a semiconductor that has a bandgap wider than that of the semiconductor of the second semiconductor layer and forms a heterojunction with the second semiconductor layer.

3. A process according to claim 1 or claim 2, wherein said doping is effected by ion implantation followed by heat treatment.

4. A process according to claim 3, wherein said heat treatment is conducted at a temperature from 600°C to 1000°C.

5. A process according to claim 4, wherein said temperature is approximately 700°C.

6. A process according to claim 3, wherein said heat treatment is flash annealing.

7. A process according to any preceding claim, wherein said first electrode is made from a heat resistant material.

8. A process according to any preceding claim, wherein said first electrode is made from one of the group of refractory metals and silicides, germanium, tellurium, silicon, cobalt, nickel, and thallium.

9. A process according to claim 8, wherein said refractory metal is tungsten, tantalum, molybdenum, titanium, vanadium, chromium, zirconium, niobium, or hafnium.

10. A process according to any one of claims 2 to 9, wherein said first semiconductor layer is made of a semiconductor that has a bandgap wider than that of the second semiconductor layer and that forms a heterojunction with the second semiconductor layer.

11. A process according to any preceding claim, wherein said first semiconductor layer is made of a compound semiconductor.

12. A process according to any preceding claim, wherein said second semiconductor layer is made of a compound semiconductor.

13. A process according to any preceding claim, wherein said third semiconductor layer is made of a compound semiconductor.

14. A process according to any preceding claim, wherein said second semiconductor layer is made of gallium arsenide and said third semiconductor layer is made of aluminum gallium arsenide.

15. A process according to any one of claims 1 to 14, wherein said first semiconductor layer is made of aluminum gallium arsenide.

16. A process according to any one of claims 1 to 13, wherein said second semiconductor layer is made of indium gallium arsenide and said third semiconductor layer is made of indium phosphide.

17. A process according to claim 16, wherein said first semiconductor layer is made of indium phosphide.

18. A process according to any one of claims 1 to 13, wherein said second semiconductor layer is made of indium gallium arsenide and said third semiconductor layer is made of aluminum indium arsenide.

19. A process according to claim 16 or 18, wherein said first semiconductor layer is made of indium gallium arsenide.

20. A process according to claim 18, wherein said first semiconductor layer is made of aluminum indium arsenide.

21. A process according to any one of claims 1 to 13, wherein said second semiconductor layer is of gallium indium antimonide and said third semiconductor layer is made of aluminum antimonide.

22. A process according to claim 21, wherein said first semiconductor layer is made of gallium indium antimonide.

23. A process according to claim 21, wherein said first semiconductor layer is made of aluminum antimonide.

24. A process according to any one of claims 1 to 13, wherein said second semiconductor layer is made of indium arsenide antimonide and said third semiconductor layer is made of aluminum arsenide.

25. A process according to claim 24, wherein said first semiconductor layer is made of indium arsenide antimonide.

26. A process according to claim 24, wherein said first semiconductor layer is made of aluminum arsenide.

27. A process according to any one of claims 1 to 13, wherein said second semiconductor layer is made of gallium arsenide and said third semiconductor layer is made of gallium indium phosphide.

6

0 130 774

28. A process according to any one of claims 1 to 14 or claim 26, wherein said first semiconductor layer is made of gallium arsenide.

29. A process according to claim 27, wherein said first semiconductor layer is made of gallium indium phosphide.

30. A process according to any preceding claim, wherein said support layer comprises a layer of a semi-insulating compound semiconductor.

31. A process according to any preceding claim, wherein said support layer comprises a silicon layer.

32. A process according to any one of claims 1 to 29, wherein said support layer comprises a sapphire layer.

33. A process according to any one of claims 1 to 29, wherein said support layer comprises a layer of a compound semiconductor of the first conductivity type.

34. A process according to any preceding claim, further comprising the step of forming a fourth semiconductor layer (15) of the first conductivity type on the third semiconductor layer, said fourth semiconductor layer having a higher carrier concentration than that of said third semiconductor layer, the fourth semiconductor layer being patterned, in the step of forming the first electrode (17), so as to have the same peripheral form as the first electrode.

35. A process according to claim 1, wherein the support layer comprises a buffer layer (11) formed on a substrate (10).

36. A process according to claim 35, wherein said buffer layer is a semiconductor layer.

37. A process according to claim 35, wherein said buffer layer is a super lattice layer.

38. A process according to any preceding claim, further comprising the step of forming a third electrode (23) for said first semiconductor layer, wherein said third electrode is formed at the same side of the support layer as the first and second electrodes.

39. A process according to claim 38, wherein the third and second semiconductor layers (14, 13) are etched, laterally outwardly of the second electrode (21), to expose part of the first semiconductor layer (12) and wherein the third electrode (23) is formed on the exposed part of the first semiconductor layer.

40. A process according to any one of claims 1 to 29, further comprising the step of forming a third electrode at the side of the support layer opposite to the first and second electrodes.

**Patentansprüche**

1. Verfahren zur Herstellung eines bipolaren Transistors mit einem Heteroübergang, mit zwei Halbleiterschichten von einem ersten Leitfähigkeitstyp, die durch eine Halbleiterschicht von einem zweiten und entgegengesetzten Leitfähigkeitstyp getrennt sind, wobei eine der Halbleiterschichten von dem ersten Leitfähigkeitstyp aus einem Halbleiter hergestellt wird, der einen Bandlücke hat, der breiter als derjenige des Halbleiters der separierenden Schicht ist und mit der separierenden Schicht einen Heteroübergang bildet, mit den folgenden Schritten:

sukzessives Bilden der ersten (12), zweiten (13) und dritten (14) Halbleiterschichten auf einer Tragschicht (10, 11);

Bildung einer ersten Elektrode (17) auf einem Teil der dritten Halbleiterschicht (14);

Durchführen der Dotierung eines Teils der genannten dritten Halbleiterschicht (14) und durch sie hindurch zu der separierenden Schicht (13) (der zweiten Halbleiterschicht), um so einen mit Verunreinigungen dotierten Halbleiterbereich (18) von dem zweiten Leitfähigkeitstyp zu bilden, der die genannte zweite Halbleiterschicht erreicht; und

Bilden einer zweiten Elektrode (21) auf dem genannten mit Verunreinigungen dotierten Halbleiterbereich (18); dadurch gekennzeichnet, daß die Dotierung der genannten dritten Halbleiterschicht durchgeführt wird unter Verwendung der ersten Elektrode als eine Maske, so daß der genannte mit Verunreinigungen dotierte Halbleiterbereich (18) mit einem Rand der ersten Elektrode ausgerichtet ist.

2. Verfahren nach Anspruch 1, bei dem die genannte dritte Halbleiterschicht aus einem Halbleiter hergestellt ist, der eine Bandbreite hat, die breiter als diejenige des Halbleiters der zweiten Halbleiterschicht ist, und mit der zweiten Halbleiterschicht einen Heteroübergang bildet.

3. Verfahren nach Anspruch 1 oder 2, bei dem die Dotierung durch Ionenimplantation und anschließende Wärmebehandlung bewirkt wird.

4. Verfahren nach Anspruch 3, bei dem die genannte Wärmebehandlung bei einer Temperatur zwischen 600°C bis 1000°C durchgeführt wird.

5. Verfahren nach Anspruch 4, bei dem die genannte Temperatur etwa 700°C beträgt.

6. Verfahren nach Anspruch 3, bei dem die genannte Wärmebehandlung eine Blitzannealbehandlung ist.

7. Verfahren nach einem der vorhergehenden Ansprüche, bei dem die genannte erste Elektrode aus feuerfestem Material hergestellt ist.

8. Verfahren nach einem der vorhergehenden Ansprüche, bei dem die genannte erste Elektrode aus einem der Gruppe von feuerfesten Metallen und Siliziden, Germanium, Tellur, Silizium, Kobalt, Nickel und Thallium hergestellt wird.

9. Verfahren nach Anspruch 8, bei dem das genannte feuerfeste Material Wolfram, Tantal, Molybdän, Titan, Vanadium, Chrom, Zirconium, Niob oder Hafnium ist.

7

10. Verfahren nach einem der Ansprüche 2 bis 9, bei dem die genannte erste Halbleiterschicht aus einem Halbleiter hergestellt ist, der einen Bandablücke hat, der breiter als derjenige der zweiten Halbleiterschicht ist und der mit der zweiten Halbleiterschicht einen Heteroübergang bildet.

11. Verfahren nach einem der vorhergehenden Ansprüche, bei dem die genannte erste Halbleiterschicht aus einem Verbindungshalbleiter hergestellt wird.

12. Verfahren nach einem der vorhergehenden Ansprüche, bei dem die genannte zweite Halbleiterschicht aus einem Verbindungshalbleiter hergestellt wird.

13. Verfahren nach einem der vorhergehenden Ansprüche, bei dem die genannte dritte Halbleiterschicht aus einem Verbindungshalbleiter hergestellt wird.

14. Verfahren nach einem der vorhergehenden Ansprüche, bei dem die genannte zweite Halbleiterschicht aus Galliumarsenid und die genannte dritte Halbleiterschicht aus Aluminiumgalliumarsenid hergestellt wird.

15. Verfahren nach einem der Ansprüche 1 bis 14, bei dem die genannte erste Halbleiterschicht aus Aluminiumgalliumarsenid hergestellt wird.

16. Verfahren nach einem der Ansprüche 1 bis 13, bei dem die genannte zweite Halbleiterschicht aus Indiumgalliumarsenid und die genannte dritte Halbleiterschicht aus Indiumphosphid hergestellt wird.

17. Verfahren nach Anspruch 16, bei dem die genannte erste Halbleiterschicht aus Indiumphosphid hergestellt wird.

18. Verfahren nach einem der Ansprüche 1 bis 13, bei dem die genannte zweite Halbleiterschicht aus Indiumgalliumarsenid und die dritte Halbleiterschicht aus Aluminiumindiumarsenid hergestellt wird.

19. Verfahren nach Anspruch 16 oder 18, bei dem die genannte erste Halbleiterschicht aus Indiumgalliumarsenid hergestellt wird.

20. Verfahren nach Anspruch 18, bei dem die genannte erste Halbleiterschicht aus Aluminiumindiumarsenid hergestellt wird.

21. Verfahren nach einem der Ansprüche 1 bis 13, bei dem die genannte zweite Halbleiterschicht aus Galliumindiumantimonid und die genannte dritte Halbleiterschicht aus Aluminiumantimonid hergestellt wird.

22. Verfahren nach Anspruch 21, bei dem die genannte erste Halbleiterschicht aus Galliumindiumantimonid hergestellt wird.

23. Verfahren nach Anspruch 21, bei dem die genannte erste Halbleiterschicht aus Aluminiumantimonid hergestellt wird.

24. Verfahren nach einem der Ansprüche 1 bis 13, bei dem die genannte zweite Halbleiterschicht aus Indiumarsenidantimonid und die genannte dritte Halbleiterschicht aus Aluminiumarsenid hergestellt wird.

25. Verfahren nach Anspruch 24, bei dem die genannte erste Halbleiterschicht aus Indiumarsenidantimonid hergestellt wird.

26. Verfahren nach Anspruch 24, bei dem die genannte erste Halbleiterschicht aus Aluminiumarsenid hergestellt wird.

27. Verfahren nach einem der Ansprüche 1 bis 13, bei dem die genannte zweite Halbleiterschicht aus Galliumarsenid und die genannte dritte Halbleiterschicht aus Galliumindiumphosphid hergestellt wird.

28. Verfahren nach einem der Ansprüche 1 bis 14 oder 26, bei dem die genannte erste Halbleiterschicht aus Galliumarsenid hergestellt wird.

29. Verfahren nach Anspruch 27, bei dem die genannte erste Halbleiterschicht aus Galliumindiumphosphid hergestellt wird.

30. Verfahren nach einem der vorhergehenden Ansprüche, bei dem die genannte Tragschicht eine Schicht aus semi-isolierendem Verbindungshalbleiter umfaßt.

31. Verfahren nach einem der vorhergehenden Ansprüche, bei dem die genannte Tragschicht eine Siliziumschicht umfaßt.

32. Verfahren nach einem der Ansprüche 1 bis 29, bei dem die Tragschicht eine Saphirschicht umfaßt.

33. Verfahren nach einem der Ansprüche 1 bis 29, bei dem die genannte Tragschicht eine Schicht aus einem Verbindungshalbleiter von dem ersten Leitfähigkeitstyp umfaßt.

34. Verfahren nach einem der vorhergehenden Ansprüche, ferner mit dem Schritt der Bildung einer vierten Halbleiterschicht (15) von dem ersten Leitfähigkeitstyp auf der dritten Halbleiterschicht, welche genannte vierte Halbleiterschicht eine höhere Trägerkonzentration als die genannte dritte Halbleiterschicht hat, die vierte Halbleiterschicht gemustert wird, bei dem Schritt der Bildung der ersten Elektrode (17), um so dieselbe Umfangsform wie die erste Elektrode zu haben.

35. Verfahren nach Anspruch 1, bei dem die Tragschicht eine Pufferschicht (11) umfaßt, die auf einem Substrat (10) gebildet wird.

36. Verfahren nach Anspruch 35, bei dem die genannte Pufferschicht eine Halbleiterschicht ist.

37. Verfahren nach Anspruch 35, bei dem die genannte Pufferschicht eine Supergitterschicht ist.

38. Verfahren nach einem der vorhergehenden Ansprüche, ferner mit dem Schritt der Bildung einer dritten Elektrode (23) für die genannte erste Halbleiterschicht, wobei die genannte dritte Elektrode an derselben Seite der Tragschicht wie die erste und die zweite Elektrode gebildet wird.

39. Verfahren nach Anspruch 38, bei dem die dritte und dei zweite Halbleiterschicht (14, 13) geätzt werden, seitlich außerhalb der zweiten Elektrode (21), um einen Teil der ersten Halbleiterschicht (12) zu exponieren, und bei dem die dritte Elektrode (23) auf dem exponierten Teil der ersten Halbleiterschicht gebildet wird.

40. Verfahren nach einem der Ansprüche 1 bis 29, ferner mit dem Schritt der Bildung einer dritten Elektrode an derselben Seite der Tragschicht gegenüber den ersten und zweiten Elektroden.


## Revendications

1. Procédé de fabrication d'un transistor bipolaire à hétérojonction comprenant deux couches semi-conductrices d'un premier type de conductivité, séparées par une couche semi-conductrice d'un second type opposé de conductivité, l'une des couches semi-conductrices du premier type de conductivité étant formée d'un semi-conducteur qui a une différence d'énergie entre bandes supérieure à celle du semi-conducteur de la couche de séparation et formant une hétérojonction avec la couche de séparation, comprenant les étapes suivantes:

la formation successive de la première (12), de la seconde (13) et de la troisième couche semi-conductrice (14) sur une couche de support (10, 11),

la formation d'une première électrode (17), sur une partie de la troisième couche semi-conductrice (14),

l'exécution du dopage d'un partie de la troisième couche semi-conductrice (14) et, à traverse elle, jusqu'à la couche de séparation (13) (la seconde couche semi-conductrice), afin qu'une région semi-conductrice (18) dopée par des impuretés et ayant le second type de conductivité et atteignant la seconde couche semi-conductrice, soit formée,

la formation d'une seconde électrode (21) sur la région semi-conductrice (18) dopée par des impuretés, caractérisé en ce que le dopage de la troisième couche semi-conductrice est réalisé avec utilisation de la première électrode comme cache afin que la région semi-conductrice (18) dopée par des impuretés soit alignée sur un bord de la première électrode.

2. Procédé selon la revendication 1, dans lequel la troisième couche semi-conductrice est formée d'un semiconducteur qui a une différence d'énergie entre bandes supérieure à celle du semi-conducteur de la seconde couche semi-conductrice et qui forme une hétérojonction avec la seconde couche semi-conductrice.

3. Procédé selon l'une des revendications 1 et 2, dans lequel le dopage est réalisé par implantation d'ions suivie par un traitement thermique.

4. Procédé selon la revendication 3, dans lequel le traitement thermique est réalisé à une température comprise entre 600 et 1000°C.

5. Procédé selon la revendication 4, dans lequel la température est d'environ 700°C.

6. Procédé selon la revendication 3, dans lequel le traitement thermique est un recuit instantané.

7. Procédé selon l'une quelconque des revendications précédentes, dans lequel la première électrode est formée d'un matériau résistant à la chaleur.

8. Procédé selon l'une quelconque des revendications précédentes, dans lequel la première électrode est formée d'un élément choisi dans le groupe qui comprend les métaux réfractaires et les siliciures, le germanium, le telluer, le silicium, le cobalt, le nickel et le thallium.

9. Procédé selon la revendication 8, dans lequel le métal réfractaire est le tungstène, le tantale, le molybdène, le titane, le vanadium, le chrome, le zirconium, le niobium ou le hafnium.

10. Procédé selon l'une quelconque des revendications 2 à 9, dans lequel la première couche semi-conductrice est formée d'un semi-conducteur qui a une différence d'énergie entre bandes supérieure à celle de la seconde couche semi-conductrice et qui forme une hétérojonction avec la seconde couche semi-conductrice.

11. Procédé selon l'une quelconque des revendications précédentes, dans lequel la première couche semi-conductrice est formé d'une composé semi-conducteur.

12. Procédé selon l'une quelconque des revendications précédentes, dans lequel la seconde couche semi-conductrice est formée d'un composé semi-conducteur.

13. Procédé selon l'une quelconque des revendications précédentes, dans lequel la troisième couche, semi-conductrice est formée d'une composé semi-conducteur.

14. Procédé selon l'une quelconque des revendications précédentes, dans lequel la seconde couche semi-conductrice est formée d'arséniure de gallium et la troisième couche semi-conductrice est formée d'arséniure de gallium et d'aluminium.

15. Procédé selon l'une quelconque des revendications 1 à 14, dans lequel la première couche semi-conductrice est formée d'arséniure de gallium et d'aluminium.

16. Procédé selon l'une quelconque des revendications 1 à 13, dans lequel la seconde couche semi-conductrice est formée d'arséniure de gallium et d'indium et la troisième couche semi-conductrice est formée de phosphure d'indium.

17. Procédé selon la revendication 16, dans lequel la première couche semi-conductrice est formée de phosphure d'indium.

18. Procédé selon l'une quelconque des revendications 1 à 13, dans lequel la seconde couche semi-conductrice est formée d'arséniure de gallium et d'indium et la troisième couche semi-conductrice est formée d'arséniure d'indium et d'aluminium.

9

19. Procédé selon l'une des revendications 16 et 18, dans lequel la première couche semi-conductrice est formée d'arséniure de gallium et d'indium.

20. Procédé selon la revendication 18, dans lequel la première couche semi-conductrice est formée d'arséniure d'indium et d'aluminium.

21. Procédé selon l'une quelconque des revendications 1 à 13, dans lequel la seconde couche semi-conductrice est formée d'antimoniure d'indium et de gallium et la troisième couche semi-conductrice est formée d'antimoniure d'aluminium.

22. Procédé selon la revendication 21, dans lequel la première couche semi-conductrice est formée d'antimoniure d'indium et de gallium.

23. Procédé selon la revendication 21, dans lequel la première couche semi-conductrice est formée d'antimoniure d'aluminium.

24. Procédé selon l'une quelconque des revendications 1 à 13, dans lequel la seconde couche semi-conductrice est formée d'antimoniure-arséniure d'indium et la troisième couche semi-conductrice est formée d'arséniure d'aluminium.

25. Procédé selon la revendication 24, dans lequel la première couche semi-conductrice est formée d'antimoniure-arséniure d'indium.

26. Procédé selon la revendication 24, dans lequel la première couche semi-conductrice est formée d'arséniure d'aluminium.

27. Procédé selon l'une quelconque des revendications 1 à 13, dans lequel la seconde couche semi-conductrice est formée d'arséniure de gallium et la troisième couche semi-conductrice est formée de phosphure d'indium et de gallium.

28. Procédé selon l'une quelconque des revendications 1 à 14, et 26, dans lequel le première couche semi-conductrice est formée d'arséniure de gallium.

29. Procédé selon la revendication 27, dans lequel la première couche semi-conductrice est formée de phosphure d'indium et de gallium.

30. Procédé selon l'une quelconque des revendications précédentes, dans lequel la couche de support est une couche d'un composé semi-conducteur semi-isolant.

31. Procédé selon l'une quelconque des revendications précédentes, dans lequel la couche de support est une couche de silicium.

32. Procédé selon l'une quelconque des revendications 1 à 29, dans lequel la couche de support est une couche de saphir.

33. Procédé selon l'une quelconque des revendications 1 à 29, dans lequel la couche de support est une couche d'un composé semi-conducteur ayant le premier type de conductivité.

34. Procédé selon l'une quelconque des revendications précédentes, comprenant en outre l'étape de formation d'une quatrième couche semi-conductrice (15) du premier type de conductivité sur la troisième couche semi-conductrice, la quatrième couche semi-conductrice ayant une concentration de porteurs supérieure à celle de la troisième couche semi-conductrice, la quatrième couche semi-conductrice étant mise sous forme d'un dessin, dans l'étape de formation de la première électrode (17), afin qu'elle ait la même forme périphérique que la première électrode.

35. Procédé selon la revendication 1, dans lequel la couche de support comporte une couche tampon (11) formée sur un substrat (10).

36. Procédé selon la revendication 35, dans lequel la couche tampon est une couche semi-conductrice.

37. Procédé selon la revendication 35, dans lequel la couche tampon est une couche de superstructure.

38. Procédé selon l'une quelconque des revendications précédentes, comprenant en outre l'étape de formation d'une troisième électrode (23) pour la première couche semi-conductrice, la troisième électrode étant formée du même côté de la couche de support que la première et la seconde électrode.

39. Procédé selon la revendication 38, dans lequel la troisième et la seconde couche semi-conductrice (14, 13) sont attaquées chimiquement latéralement vers l'extérieure par rapport à la seconde électrode (21) afin qu'une partie de la première couche semi-conductrice (12) soit exposée, et dans lequel la troisième électrode (23) est formée sur la partie exposée de la première couche semi-conductrice.

40. Procédé selon l'une quelconque des revendications 1 à 29, comprenant en outre l'étape de formation d'une troisième électrode du côté de la couche de support qui est opposé à celui de la première et de la seconde électrode.

# Fig. 1

$E_F$ $E_C$ _____ p-GaAs (BASE)

n-Al$_x$Ga$_{1-x}$As (EMITTER)

$E_V$ _____

$E_C$ _____ $E_F$

n-GaAs (COLLECTOR)

$E_V$

# Fig. 2

## Fig. 3

## Fig. 4

Fig. 5

Fig. 6